## Europäisches Patentamt

## European Patent Office

## Office européen des brevets

(11) Publication number: **0 220 605 B1**

## (12) EUROPEAN PATENT SPECIFICATION

(45) Date of publication of patent specification: **12.12.90**

(51) Int. Cl.⁵: **H 01 L 21/265,** H 01 L 21/28, H 01 L 29/76

(21) Application number: **86114251.1**

(22) Date of filing: **15.10.86**

(54) Method of making self-aligned GaAs digital integrated circuits.

(30) Priority: **21.10.85 US 789523**

(43) Date of publication of application:
**06.05.87 Bulletin 87/19**

(45) Publication of the grant of the patent:
**12.12.90 Bulletin 90/50**

(84) Designated Contracting States:
**DE FR GB IT NL**

(56) References cited:
**WO-A-85/00077**
**US-A-4 711 701**
**US-A-4 712 291**

**PATENT ABSTRACTS OF JAPAN vol. 6, no. 251 (E-147)(1129), December 10, 1982 & JP-A-57-152 168**

**JOURNAL OF THE ELECTROCHEMICAL SOCIETY: SOLID STATE SCIENCE vol. 118, no. 11, January 1971, pages 118-122; Y. TARUI et al.: "Preferential Etching and Etched Profile of GaAs"**

(73) Proprietor: **ITT INDUSTRIES INC.**
**320 Park Avenue**
**New York, NY 10022 (US)**

(72) Inventor: **Sadler, Robert Allen**
**2044 Denise Circle**
**Roanoke Virginia 24012 (US)**
Inventor: **Geissberger, Arthur Eugene**
**3332 Circle Brook Drive S.W.**
**Roanoke Virginia 24014 (US)**

(74) Representative: **Vaufrouard, John Charles et al**
**RUFFHEAD & VAUFROUARD Maidstone Road (S.T.C. Site) Foots Cray**
**Sidcup Kent DA14 5HT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

### Background of the Invention

This invention relates to gallium arsenide (GaAs) field-effect transistors (FETs) and to methods of making such transistors. More particularly, this invention is concerned with a method for making self-aligned gate (SAG) GaAs transistors for use in the integrated circuit field.

The processes currently being used fall into two categories: (1) Thermally-Stable Refractory Gate (RG), and (2) Substitutional Gate (SG). From a processing standpoint, the RG process is simpler and easier to manufacture that the SG process, but it places stringent requirements on the thermal stability of the Schottky gate metallization. The SG approach places no unusual thermal stability requirements on the gate metal but does require the difficult formation of a tri-layer gate substitution mask with a carefully controlled T-shaped profile.

While the RG approach may be superior overall to the SG approach, previous embodiments of the RG approach have suffered from the need to compromise some aspects of the process due to inadequate technology. A major problem in the past has been that the thermal stability of the gate metal is insufficient to permit annealing of the self-aligned n+ implant at temperatures higher than 750—800°C, whereas optimum activation of the channel implants of the device occurs at around 830—850°C. This necessitates one of two possible compromises: either annealing both types of implant together at the lower temperature as disclosed in WO—A—8500077, or doing two separate anneals, one at each temperature. In either case, the implant activation and electron mobility suffer, so that the FET characteristics are less than optimum.

Another disadvantage of some embodiments of the RG approach is the use of a photoresist mask to plasma etch the refractory gate metal. Thus, since this approach results in an FET without an overhanging "T-gate" structure, it allows no means to control the position of the gate between the edges of the self-aligned n+ regions, and therefore no means to optimize the gate structure with respect to both capacitance and series resistance.

The Japanese Patent Abstract corresponding to JP—A—57152168, published in Patent Abstracts of Japan Vol. 6 No. 251 (E-147) (1129) discloses a method for producing a self-aligned Schottky FET with a gate metallization comprising metals such as Nb, Mo, W as well as alloys of these metals containing less than 20 atomic percent of the metals Ti, Cr or Zr.

### Objects of the invention

It is therefore an object of the present invention to provide a self-aligned gate type GaAs field-effect transistor which overcomes the disadvantages of the prior art.

It is an additional object of the present invention to provide a refractory gate metallization with high thermal stability.

It is yet another object of the present invention to provide a method of manufacturing a GaAs field-effect transistor using a single annealing step.

It is an additional object of the present invention to provide a method of producing GaAs field-effect transistors in which the throughput is increased and the cost is decreased.

It is still a further object to provide a process which permits the use of a high-resolution positive photoresist to define a metal etch mask by liftoff.

It is another object to provide a FET which allows gate line widths of 1 µm or less to be easily defined.

It is yet another object to provide a metal mask which serves as an implant mask thereby allowing the creation of an implant-to-implant spacing larger than the gate length.

### Summary of the invention

These objects and others which will become apparent hereinafter are accomplished by the present invention as defined in the claim which provides a process of making a field-effect transistor comprising the step of heating a gallium arsenide substrate having ions implanted therein and a metallization layer consisting of a mixture of 1 to 20 atomic percent titanium and the remaining atomic percent tungsten deposited on the substrate to a temperature in the range 830—850°C to anneal the substrate and activate the implanted ions therein.

### Brief description of the drawing

The above-mentioned and other features and objects of this invention will become more apparent by reference to the following description taken in conjunction with the accompanying drawings in which:

Fig. 1 is a schematic sectional view of a field-effect transistor produced in accordance with the present invention; and

Figs. 2 through 7 show the steps of forming a field-effect transistor in accordance with this invention.

### Detailed description of the preferred embodiment

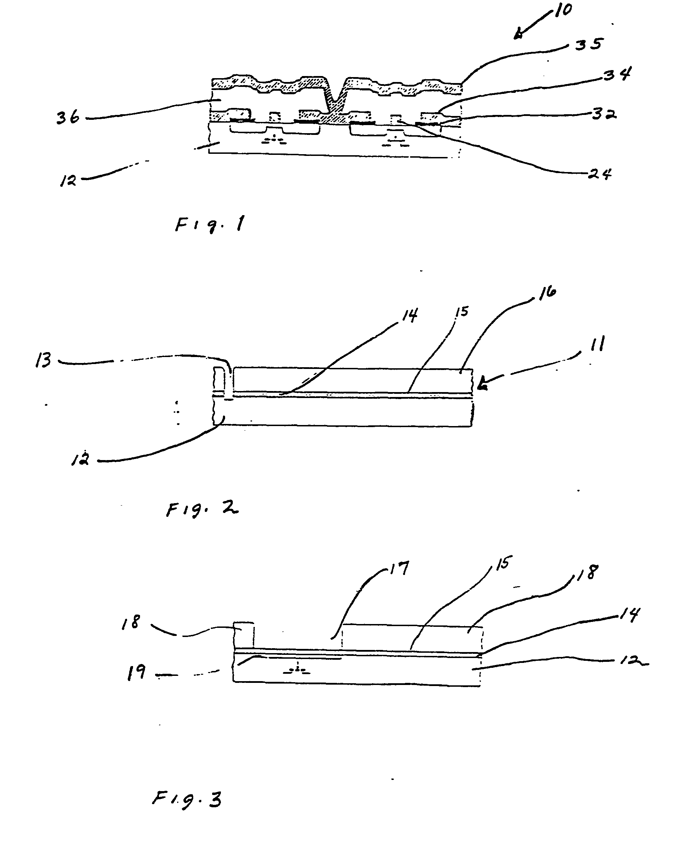

Fig. 1 shows the structure of a self-aligned gate field-effect transistor in accordance with the present invention generally indicated by 10.

Processing of a semiconductor wafer 11 will now be described. Referring to Fig. 2, a gallium arsenide (GaAs) substate 12 is initially cleaned in solvents and then etched to remove that portion of the substrate 12 which may have been damaged by the use of a mechanical slurry polishing process. It has been found that by removing at least approximately 5 µm from each of the substrate surfaces the damaged portion will be removed and improved electrical properties will result. A problem in removing the material from the substrate is that a pitted or rough-textured surface may result with certain etchants. A preferred etchant which avoids this problem is a mixture of sulfuric acid, hydrogen peroxide and water $(H_2SO_4: H_2O_2: H_2O)$ in a ratio of 5:1:1, used at a temperature in the range of approximately 30—40°C. This etchant does not damage the wafer 11 and leaves a smooth finish on the surfaces of the wafer 11 which aids in further processing of the wafer, especially when performing photolithography.

A dielectric layer 14 which will serve as a passivation layer for the GaAs is formed on one surface of the substrate 12 with 90 nm (900 Å) or less of a suitable dielectric material. The preferred materials for the dielectric layer 14 are silicon nitride (SiN), silicon oxy-nitride (SiON) or silicon dioxide ($SiO_2$). The formation of the dielectric layer 14 protects the substrate surface by isolating it from photoresist residues during later processing. The dielectric layer 14 may, however, be eliminated so that ion implants are made directly into the bare GaAs surface.

A photoresist layer 16 is formed on one surface 15 of the dielectric layer 14. The photoresist layer 16 is patterned for registration marks 13 which will serve to align masks on the wafer 11 for patterning implant areas later in the process. The pattern of registration marks 13 are etched into the dielectric layer 14 and then into the underlying GaAs substrate 12. After etching, the photoresist layer 16 is removed, preferably with an oxygen plasma.

Another photoresist layer 18 is formed on the surface 15 as shown in Fig. 3. The photoresist layer 18 is patterned to form one or more windows 17 for selective ion implantation through the dielectric layer 14 into the underlying GaAs substrate 12. Patterning is performed in any known manner. Typically, a photographic mask having the desired pattern is postioned on the photoresist layer 18, aligning registration marks on the mask with the registration marks on the substrate 12. The photoresist 18 is exposed to light through the mask, and then the mask is removed. A solvent is applied so that the exposed areas of the resist are dissolved and washed away and the unexposed resist remains to serve as an implant mask.

The ion implanation step is performed in any known manner. The one method, the wafer 11 is supported in a vacuum chamber and a beam of ions is uniformly swept over it and implanted into the GaAs substrate 12 through the window 17. The implanted region is indicated at 19. The material of the dielectric layer 14 has an amorphous structure, thus minimizing planar channeling effects of the arriving ions through the layer 14. If somewhat steeper implant profiles are desired, the dielectric layer 14 may be eliminated and the implant made directly into the GaAs substrate 12. After the implant is performed, the photoresist layer 18 is removed in an oxygen plasma.

Additional selective implant steps may be performed by forming another photoresist layer on top of the dielectric layer 14, patterning the photoresist layer to form window areas and implanting the desired material through the window area into the dielectric layer 14 and into the GaAs substrate 12. The photoresist 18 is thereafter removed. Thus, many different types of active and passive devices can be fabricated on the same wafer, for example, enhancement-mode and depletion-mode FETs, diodes and resistors.

After completing the desired selective implant steps, the dielectric layer 14 is removed in hydrogen fluoride (HF). A metallization layer 20 is formed on a surface 26 which is the implanted surface of the wafer 11. The metallization layer 20 is formed of titanium-tungsten (TiW). One method of formation of the layer 20 is accomplished by the sputter deposition of titanium-tungsten to a depth of 200 nm (2000 Å). Known metallization layers consist of titanium and tungsten in an atomic ratio of 30:70. This is equivalent to 10 weight percent titanium and 90 weight percent tungsten. Sputter targets of this composition were originally employed in the silicon semiconductor industry to sputter deposit a titanium-tungsten diffusion barrier layer between, for example, aluminum and polysilicon. When these sputter targets were used in the gallium arsenide industry to deposit titanium-tungsten to form a temperature-stable Schottky contact, it was found that annealing at temperatures higher then 800°C caused degradation of the electrical properties of the TiW:GaAs Schottky barrier. It therefore became necessary to perform two annealing steps—one at a temperature of 830—850°C to achieve optimum activation of the channel implants and a second after the high-dose ion implant, at a lower temperature of 750—800°C to prevent functional degradation of the Schottky gate. The second low-temperature annealing resulted in less than optimum levels of implant activation and electron mobility for the following reasons. Typically, silicon is used as an ion-implanted dopant for GaAs. Silicon may act as an n-type or p-type dopant. Annealing time and temperature will determine whether the silicon acts as an electron donor (n-type) or an electron acceptor (p-type). At higher annealing temperatures the number of silicon atoms which become electron donors increases. This is the desired condition since n-type GaAs material has higher electron mobility. Thus, annealing at lower temperature results in less implant activation and electron mobility.

Unexpectedly, it has been found that a mixture of 1 atomic percent titanium to 20 atomic percent titanium with a respective 99 to 80 atomic percent tungsten ratio in the deposited layer 20 gives thermal stability to the layer so that it can withstand annealing at temperatures between 800—950°C without degradation of the electrical properties of the titanium-tungsten: gallium arsenide Schottky barrier. Preferably, annealing is performed at temperatures in the range of approximately 830—850°C to achieve optimum ion implant activation. Due to the thermal stability of the metallization layer 20 at high temperatures, it became possible to perform only one annealing step at the higher temperatures, resulting in optimum activation of each implant, increased electron mobility and reduced parasitic resistances. Other improved FET characteristics which result from the single higher-temperature annealing step include operation of the circuit at a lower drain-source bias voltage which results in low power dissipation, or faster switching time with the same power dissipation. With higher percentages of titanium in the mixture, the thermal stability begins to degrade. Thus, with the reduced titanium level of this invention, the stability of the TiW during high temperature processing is achieved.

One way of achieving reduced atomic percent titanium in the metallization layer is by changing the sputter conditions. In a typical sputtering process, the wafer 11 is placed in a vacuum chamber and a 30:70 TiW target electrode is used as a cathode in an RF circuit. Argon gas is passed into the chamber at a low pressure and bombards the TiW cathode releasing TiW onto the wafer 11. By changing certain sputter conditions including the pressure conditions inside the chamber and the biasing of the wafer 11, the ratio of atoms of titanium is reduced from 30 per hundred resulting in improved thermal stability of the deposited layer.

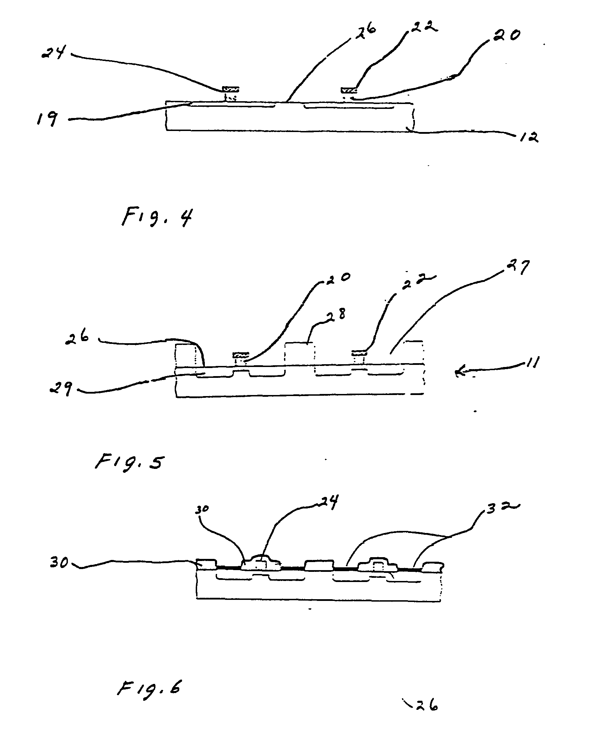

Referring to Fig. 4, the next step in wafer processing is the patterning of the gate structures 24 which begins with the formation of another masking level on the TiW layer 20. This masking level is a metal etch mask 22 formed by liftoff in the following manner. A high resolution positive photoresist mask is positioned on top of the TiW layer 20. The positive photoresist mask has openings which define the regions where a metal is to be deposited which will form the etch mask 22. The metal for the etch mask 22 is evaporated on the positive photoresist mask in such a manner that the openings in the mask are filled. After evaporation, the photoresist mask is lifted-off and the metallization remaining on the TiW layer 20 defines the metal etch mask 22. Preferred materials for the etch mask 22 are either nickel or aluminum.

It has been found that the use of a high-resolution positive photoresist to define a metal etch mash by liftoff enables gates linewidths of 1 μm or less to be defined much more easily than with the use of a photoresist etch mask. In addition, the metal etch mask 22 serves as an excellent implant mask as discussed below. This high resolution positive photoresist/liftoff step is performed again in subsequent processing of the wafer 11.

The underlying TiW layer 20 is then reactive-ion etched, using the metal mask 22, in a fluorine-based plasma. The plasma will etch the TiW layer 20 in the regions not covered by the metal etch mask 22 and will also undercut the masked region to form T-shaped gate structures 24 as shown in Fig. 4. The amount of plasma undercut can be controlled by varying the plasma etch paramters. This can be accomplished by initially etching at low pressure to set an anisotropic profile, then increasing the pressure to achieve a faster plasma undercut.

Following the gate patterning, a photoresist mask 28 is formed on the surface 26 to define regions 29 for self-aligned ion implant as shown in Fig. 5. The term "self-aligned" is used since the mask 22 acts as a barrier to ion implantation by an ion beam and thus defines the limits of heavily doped regions in the substrate. While n-type doping levels are used for the initial channel implant at a level which will form good Schottky contact, much higher levels of doping ($n^+$) are used during this implant step to facilitate ohmic contact. Although p and $p^+$ implants may be used for Schottky contact and ohmic contact, respectively, n-type doping permits much faster carrier transport.

The photoresist mask 28 is formed by depositing a layer of a positive photoresist on the wafer 11 and exposing the photoresist 28 through a mask in those areas in which implant is desired. The mask and the exposed portion of the photoresist are removed. Windows 27 for the high-dose ion implant are thereby formed on the surface 26 of the wafer 11. The metal etch mask 22 serves as a self-aligned structure for the ions which are directed to the window regions. The ions will be implanted in the regions at both sides of the gate structures 24, with a small lateral separation between each gate edge and adjacent $n^+$ region. The metal etch mask 22 allows the creation of an implant-to-implant spacing larger than the gate length. This is an important feature of an optimized GaAs SAG process, since only by controlling the difference between these two dimensions can the device be optimized in the trade-off between gate capacitance and breakdown voltage versus parasitic series resistance.

The $n^+$ implant is masked from the region of the gate structures 24 by the etch mask 22, with the separation of each gate edge from the adjacent $n^+$ region determined by the plasma undercut of the gate metal. The plasma undercut can be controlled accurately enough to allow optimization of the gate structure with respect to both gate capacitance and series resistance. The photoresist mask 28 is removed in an $O_2$ plasma, and the etch mask 22 is dissolved in hydrochloric acid at 55°C, which also removes any photoresist residues which may remain.

The wafer is then covered with approximately 300 nm (3000 Å) or less of a dielectric encapsulant 30 and annealed at approximately 850°C for 20 minutes. The encapsulant 30 protects the GaAs wafer 11 from disassociation since the arsenic may vaporize at the high annealing temperature. Because the atomic ratio of the TiW elements enables the layer 20 to have unusually high thermal stability, only one annealing step for both channel and ion implants is needed. As discussed above, this allows optimum activation of each implant, higher electron mobility, reduced parasitic resistances and superior device characteristics. It also eliminates one annealing furnace and the need for two separate annealing process steps thereby resulting in decreased fabrication costs. The dielectric encapsulant 30 may be any one of chemical-vapor-deposited silicon dioxide (SiO$_2$), silicon nitride (SiN) or silicon oxy-nitride (SiON).

The next step is the formation of ohmic contacts 32 on the surface 26. This may be accomplished in either one of two ways. In one method the annealing encapsulant 30 is removed in hydrofluoric acid and contacts 32 are formed by evaporation and liftoff. The lift-off step is performed in the same manner as discussed hereinbefore with respect to the formation of the etch mask 22.

In a second preferred method as shown in Fig. 6 the annealing encapsulant 30 is left in place on the wafer 11 and embedded contacts 32 are formed by plasma etching the ohmic contact patterns through the encapsulant to the surface 26, then evaporating the metallization into the etched pattern and lifting off the pattern.

Preferred materials for the contacts 32 are a first layer of a gold-germanium compound overlayed with nickel. While the first method is simpler from a processing standpoint, the second method has the advantage of provding complete gate passivation, leading to greater device reliability. With either approach, the material of the contacts 32 may be deposited by sputtering rather than evaporation, with the advantage of better surface cleaning and more reproducible contact properties.

In either case, the contacts 32 are alloyed into the GaAs surface 26 by rapidly heating to 400°C for 10 seconds, preferably with quartz-halogen tungsten lamps.

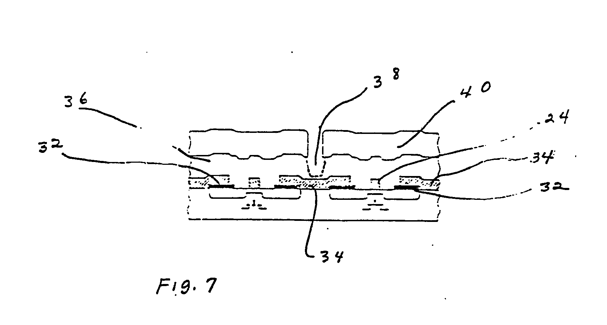

Referring to Fig. 7, after the ohmic contacts 32 are alloyed, a first-level conductive interconnect metal 34 is formed on the surface 15 by liftoff. This metal layer 34 overlays the ohmic contacts 32 and makes connection to the small gate pads at the end of each gate finger. The gate metal itself is not useful for circuit interconnections because of its high resistivity, so the conductive layer 34 serves this purpose. The preferred materials for the layer 34 are either titanium-paladium-gold or titanium-platinum-gold.

To form a second-level interconnect metallization, the wafer is next coated wtih a suitable dielectric material to form a layer 36. An organic material such as polyimide may be used for the dielectric material. Other dielectric materials include inorganic materials such as plasma-deposited SiN or SiON. Contact vias 38 are opened in the dielectric layer 36 by plasma etching through a patterned photoresist layer 40. The contact vias 38 permit contact between the additional level of interconnect metallization with the underlying first-level interconnect metal 34 as shown in Fig. 7.

The second-level interconnect metal is deposited and patterned either by liftoff or etching, in such a way that it fills the via openings and contacts the first-level metal, as shown in Fig. 1.

Additional levels of interconnection may be formed in the same way, and, if desired, the wafer can be given a final dielectric passivation coating for scratch protection.

The wafer is then diced into chips.

While we have described above the principles of our invention in connection with specific apparatus, it is to be clearly understood that this description is made only by way of example and not as a limitation to the scope of our invention as set forth in the objects thereof and in the accompanying claim.

**Claim**

A process of making a gallium arsenide field-effect transistor, wherein first and second doses of an impurity are implanted into a gallium arsenide substrate, a metal gate of titanium-tungsten having between 1 and 20 atomic percent titanium is formed following the implanting of the first dose of impurity and used as an implant mask during implanting of the second dose of impurity into the gallium arsenide substrate and, the gallium arsenide substrate is annealed to activate both the first and second doses of the implanted impurity by heating the substrate to a temperature in the range 830 to 850 degrees Centigrade for about 20 minutes.

**Patentanspruch**

Verfahren zur Herstellung eines Galliumarsenid-Feldeffekt-transistors, bei dem eine erste und eine zweite Menge eines Dotierstoffes in ein Galliumarsenidsubstrat implantiert werden, nach dem Implantieren der ersten Dotierstoffmenge ein Metall-Gate aus Titan-Wolfram mit einem Titan-Anteil zwischen 1 und 20 Atomprozent gebildet und als eine Implantationsmaske während des Implantierens der zweiten Dotierstoffmenge in das Galliumarsenid-Substrat verwendet wird und das Galliumarsenid einer Ausheilung unterzogen wird, um sowohl die erste als auch die zweite implantierte Dotierstoffmenge durch Erhitzen des Substrats auf eine Temperatur im Bereich von 830 bis 850°C für etwa 20 Minuten zu aktivieren.

**Revendication**

Procédé de réalisation d'un transistor à effet de champ à arséniure de gallium, dans lequel une première et une seconde doses d'une impureté sont implantées dans un substrat d'arséniure de gallium, une grille métallique de titane-tungstène ayant un pourcentage atomique de titane compris entre 1 et 20 est formée après l'implantation de la première dose d'impureté et utulisée comme un masque d'implantation pendant l'implantation de la seconde dose d'impureté dans le substrat d'arséniure de gallium et le substrat d'arséniure de gallium est recuit pour activer la première et la seconde doses de l'impureté implantée en chauffant le substrat à une température dans la plage de 830 à 850° degrés centigrade pendant environ 20 minutes.

10

35

34

32

36

24

12

F i g. 1

16

14    15    11

13

12

F i g. 2

17    15    18

18

14

19    12

F i g. 3

Fig. 4

Fig. 5

Fig. 6

Fig. 7